# EUROPÄISCHE PATENTANMELDUNG

(11) **EP 1 154 679 A1**
(43) Veröffentlichungstag der Anmeldung: **14.11.2001**
(21) Anmeldenummer: 01111664.7
(22) Anmeldetag: 14.05.2001
(51) Int. Cl.: H05K 7/20, H01L 23/473

(54) **Kühleinheit für ein elektronisches Bauteil, sowie Kühlsystem für einen Rechner**

(30) Priorität: 12.05.2000 DE 10023266
(71) Anmelder: Reid, Troy, 63075 Offenbach/Main (DE)
(72) Erfinder: Reid, Troy, 63075 Offenbach/Main (DE)
(74) Vertreter: Staudt, Armin Walter

(57) **Zusammenfassung**

Bei einer bekannten Kühleinheit für ein elektronisches Bauteil ist ein Gehäuse vorgesehen, das einen Einlass und einen Auslass für eine Kühlflüssigkeit aufweist, und das mit einer metallischen Kühlfläche versehen ist, die mit dem elektronischen Bauteil in flächigem, thermischen Kontakt steht. Um hiervon ausgehend eine kompakte und leichte Kühleinheit anzugeben, die einfach und preiswert zu fertigen ist, und die flexibel an das zu kühlende Bauteil angepaßt werden kann, wird erfindungsgemäß vorgeschlagen, dass das Gehäuse ein einseitig offenes Hohlprofil umfasst, das mit einer Kühlplatte, die mit dem elektronischen Bauteil in flächigem, thermischen Kontakt steht, flüssigkeitsdicht verschlossen ist. Ein einfaches und kostengünstiges Kühlsystem gemäß der Erfindung, das eine geräuscharme oder geräuschfreie Kühlung von Personalcomputern für den Einsatz in Industrie, Büro oder als Heimcomputer ohne großen apparativen Aufwand erlaubt, zeichnet sich dadurch aus, dass der Prozessor (52) und die Graphikkarte (54) jeweils mit mindestens einer Kühleinheit (63, 65) nach einem der vorhergehenden Ansprüche in thermischem Kontakt sind, wobei die Kühleinheiten (63, 65) fluidisch miteinander verbunden sind.

## Beschreibung

Die vorliegende Erfindung betrifft eine Kühleinheit für ein elektronisches Bauteil, umfassend ein Gehäuse, das einen Einlass und einen Auslass für eine Kühlflüssigkeit aufweist, und das mit einer metallischen Kühlfläche versehen ist, die mit dem elektronischen Bauteil in flächigem, thermischen Kontakt steht.

Weiterhin betrifft die Erfindung ein Kühlsystem für einen elektronischen Rechner, der einen Prozessor, eine Graphikkarte und eine Festplatte aufweist.

Elektronische Rechner enthalten eine Vielzahl stromdurchflossener und im Betrieb wärmeerzeugender Bauteile. Mit zunehmender Integrationsdichte und Leistungsaufnahme der elektronischen Bauteile - insbesondere der Mikroprozessoren - steigt das Erfordernis, diese Wärme abzuführen, um eine Überhitzung und damit eine Beschädigung der Bauteile zu vermeiden. Häufig wird die Wärme durch Luftkühlung unter Einsatz eines oder mehrerer Gebläse von den elektronischen Bauteilen abgeführt. Der Einsatz von Gebläsen zieht eine gewisse Geräuschentwicklung nach sich. Es ist auch bekannt, die Wärme von den Bauteilen durch flächigen Kontakt mit Kühlkörpern, wie Kühlrippen oder Peltierelementen, abzuführen, wobei diese Verfahren jedoch im allgemeinen eine geringe Effizienz haben.

Eine Kühleinheit der eingangs genannten Gattung, bei der eine Kühlflüssigkeit eingesetzt wird, ist in der EP-A1 641 155 beschrieben. Die daraus bekannte Kühleinheit ist als Wärmetauscher für ein elektronisches Bauteil in Form eines geschlossenen, quaderförmigen Gehäuses ausgebildet, das stirnseitig einen Einlass und einen Auslass für eine Kühlflüssigkeit aufweist. Zur Kühlung eines elektronischen Bauteils wird durch das Gehäuse eine Kühlflüssigkeit geleitet. Innerhalb des Gehäuses sind eine Vielzahl von Kühlrippen parallel zueinander so angeordnet, dass sie von der einströmenden Kühlflüssigkeit mäanderförmig umströmt werden. Das Gehäuse weist eine obere und eine untere Flachseite auf, die bei thermischem Kontakt mit dem zu kühlenden elektrischen Bauteil als Wärmetauscher wirkend von diesem überschüssige Wärme abführen.

Das bekannte Kühlelement ist konstruktiv sehr aufwendig gestaltet, hat eine relativ große Bauhöhe und aufgrund der Kühlrippen ein hohes Gewicht.

Komplette Kühlsysteme für derartige Rechner umfassen im allgemeinen mehrere unabhängige Kühleinheiten. Diese sind aufwendig und teuer. Im Fall von Kühleinheiten in Form von Gebläsen ist die so erzeugte Luftkühlung darüberhinaus mit einer häufig störenden Geräuschentwicklung verbunden.

Der Erfindung liegt daher die Aufgabe zugrunde, eine kompakte und leichte Kühleinheit anzugeben, die einfach und preiswert zu fertigen ist, und die flexibel an das zu kühlende Bauteil angepaßt werden kann. Weiterhin liegt der Erfindung die Aufgabe zugrunde, ein einfaches und kostengünstiges Kühlsystem anzugeben, das eine geräuscharme oder geräuschfreie Kühlung von Personalcomputern für den Einsatz in Industrie, Büro oder als Heimcomputer ohne großen apparativen Aufwand erlaubt.

Hinsichtlich der Kühleinheit wird diese Aufgabe ausgehend von der eingangs beschriebenen Kühleinheit erfindungsgemäß dadurch gelöst, dass das Gehäuse ein einseitig offenes Hohlprofil umfasst, das mit einer Kühlplatte, die mit dem elektronischen Bauteil in flächigem, thermischen Kontakt steht, flüssigkeitsdicht verschlossen ist.

Die erfindungsgemäße Kühleinheit umfasst ein Hohlprofil, das mit einer Kühlplatte flüssigkeitsdicht verschlossen ist. Beim bestimmungsgemäßen Einsatz der Kühleinheit wird das Hohlprofil von einer Kühlflüssigkeit, beispielsweise Wasser, durchströmt. Die Kühlplatte liegt dabei im einfachsten Fall mit ihrer dem Hohlprofil abgewandten Flachseite flach auf dem zu kühlenden elektronischen Bauteil direkt auf. Sie kann auch in thermischem Kontakt mit dem zu kühlenden Bauteil stehen, wobei der thermische Kontakt beispielsweise durch ein weiteres metallisches Bauteil, eine Wärmeleitpaste oder durch ein Peltierelement gebildet wird. Es können außerdem auch gleichzeitig mehrere elektronische Bauteile mittels der Kühlplatte gekühlt werden. Üblicherweise sind am Hohlprofil der Einlass und der Auslass für die Kühlflüssigkeit vorgesehen.

Im einfachsten Fall bestehen sowohl das Hohlprofil, als auch die Kühlplatte aus einfach zu fertigenden Bauteilen. Das Hohlprofil kann beispielsweise als Halbkugel, Halbschale oder becherförmig mit rundem oder rechteckigem Querschnitt ausgebildet sein. Der Hohlraum kann durch mechanische Bearbeitung eines Vollkörpers, etwa durch Bohren, Drehen, Fräsen oder dergleichen erhalten werden.

Die Länge und Breite der Kühleinheit wird durch die seitlichen Abmessungen der Kühlplatte bestimmt. Als Höhe der Kühleinheit wird die Abmessung senkrecht dazu verstanden. Bei Einsatz eines flachen Hohlprofils wird eine Kühleinheit mit geringer Bauhöhe erhalten. Als Werkstoff für die Kühlplatte kommt in erster Linie ein gut wärmeleitendes Metall in Frage. Das Hohlprofil kann aus dem gleichen Werkstoff wie die Kühlplatte gefertigt sein.

Die offene Seite des Hohlprofils ist mit der Kühlplatte verschlossen. Die Länge und Breite der Kühlplatte ist besonders einfach an die Abmessungen des zu kühlenden elektronische Bauteil anpassbar. Im Idealfall ist die Kühlplatte eben, sie kann aber auch verschiedene Ebenen aufweisen, um einen gleichzeitigen flächigen Kontakt mit zu kühlenden Bauelementen mit unterschiedlichen Höhen zu ermöglichen. Bei einer lösbar mit dem Hohlprofil verbundenen Kühlplatte kann diese bei Bedarf leicht ausgetauscht werden.

Die erfindungsgemäße Kühleinheit ist somit einfach und preiswert zu fertigen und sie ist flexibel an das zu kühlende Bauteil anpassbar. Die Kühlung des Bauteils erfolgt geräuschfrei.

Die Herstellung der Kühleinheit gestaltet sich besonders einfach, wenn das Hohlprofil einstückig aus einem Metall- oder Kunststoffteil gefertigt ist. Der Hohlraum wird dabei durch mechanische Bearbeitung des Metall- oder Kunststoffteils, etwa durch Ausbohren, -drehen oder -fräsen erhalten. Aufgrund seiner guten Wärmeleitfähigkeit werden als Metalle vorzugsweise Kupfer, Messing oder Aluminium eingesetzt, wobei Aluminium sich durch eine vergleichsweise günstigen Preis auszeichnet. Beim Einsatz von Kunststoff ist neben einer guten Wärmeleitfähigkeit auf eine ausreichende thermische Stabilität zu achten.

Es wird eine Ausführungsform der Kühleinheit bevorzugt, bei der das Hohlprofil in einer Ebene parallel zur Flachseite der Kühlplatte einen runden Innenquerschnitt aufweist. Ein runder Innenquerschnitt ist durch mechanische Bearbeitung besonders einfach herstellbar.

Vorteilhafterweise ist die Kühleinheit mit dem zu kühlenden elektronischen Bauteil lösbar verbunden. Gegebenenfalls kann das elektronische Bauteil leicht ausgetauscht werden, zum Beispiel bei einer Um- oder Aufrüstung des Rechners oder im Defektfall. Die lösbare Verbindung sollte in jedem Fall einen innigen thermischen Kontakt zwischen Bauteil und Kühlplatte gewährleisten. Es kommen die bekannten Verbindungsmittel, wie Schrauben, Federn, Klemmen oder auch doppelseitiges Klebeband in Frage.

Besonders bewährt hat sich eine Kühlplatte, die mit Öffnungen versehen ist, die in einem Raster oder in mehreren vorgegebenen Rastern angeordnet sind. Die Öffnungen dienen zur Befestigung der Kühleinheit am zu kühlenden Bauteil. Hierzu greifen Befestigungselemente durch die Öffnungen am Bauteil an. Die Raster der Öffnungen können an die gängigen Abmessungen der zu kühlenden Bauteile angepasst sein, wie etwa an die Abmessungen der aktuellen Mikroprozessoren, so dass im Falle eines Austauschs des Bauteils die Kühleinheit weiterhin verwendet werden kann.

Es wird eine Ausführungsform der Kühleinheit bevorzugt, die einen mit einer Warnvorrichtung versehenen Temperatursensor und/oder einen mit einer Warnvorrichtung versehenen Feuchtigkeitssensor und/oder eine mit einer Warnvorrichtung versehene Durchfluss-Sensor und/oder einen mit einer Anzeige versehenen Füllstandssensor umfasst. Temperatursensor, Feuchtigkeitssensor oder Durchfluss-Sensor dienen zur Überwachung des ordnungsgemäßen Betriebs der Kühleinheit. Der Füllstandssensor dient zur Überwachung eines ausreichenden Füllstands in einem Bad der Kühlflüssigkeit. Mittels des Temperatursensors wird die Temperatur des zu kühlenden Bauteils überwacht. Für den Fall einer Betriebsstörung wird diese durch eine optische oder akkustische Warnvorrichtung angezeigt, beispielsweise durch eine Reihe von LEDs.

Wegen ihrer leicht anpassbaren Größe und ihrer einfachen Austauschbarkeit ist die erfindungsgemäße Kühleinheit universell zur Kühlung elektronischer Bauteile einsetzbar. Abgesehen von der Kühlung von Mikroprozessoren ist sie jedoch besonders für die Kühlung einer Graphikkarte und/oder einer Festplatte geeignet.

Hinsichtlich des Kühlsystems für einen elektronischen Rechner wird die oben angegebene Aufgabe ausgehend vom eingangs beschriebenen Kühlsystem erfindungsgemäß dadurch gelöst, dass der Prozessor und die Graphikkarte jeweils mit mindestens einer erfindungsgemäßen Kühleinheit in thermischem Kontakt sind, wobei die Kühleinheiten fluidisch miteinander verbunden sind.

Für die Kühlung von Prozessor und Graphikkarte ist jeweils mindestens eine erfindungsgemäße Kühleinheit vorgesehen, so dass andere Kühlmaßnahmen insoweit nicht erforderlich sind. Im Bedarfsfall kann das Kühlsystem auch durch weitere erfindungsgemäße Kühleinheit ergänzt werden, etwa für eine zweite Festplatte.

Alle Kühleinheiten sind fluidisch miteinander verbunden. Es ist somit nur eine Flüssigkeitspumpe für den Transport der Kühlflüssigkeit durch alle Kühleinheiten erforderlich. Darüberhinaus ist auch der apparative Aufwand für die Funktionsüberwachung des Kühlsystems gering.

Üblicherweise ist das Kühlsystem mit einem Temperatursensor und/oder einem Feuchtigkeitssensor und/oder einem Durchfluss-Sensor versehen, wobei alle diese Messeinheiten eine Warnvorrichtung umfassen können , wie dies oben anhand der erfindungsgemäßen Kühleinheit näher erläutert ist.

Das erfindungsgemäße Kühlsystem ermöglicht es nicht nur, einen Rechner geräuscharm oder geräuschlos zu betreiben, sondern auch die Lebensdauer der Bauteile wird durch die effektive Kühlung verlängert. Darüberhinaus ist das Kühlsystem auch als Komplettsystem für eine Übertaktung des Rechners geeignet.

Es wird eine Ausführungsform des Kühlsystem bevorzugt, bei der eine weitere, mit der Festplatte in thermischem Kontakt stehende Kühleinheit vorgesehen ist, die mit den Kühleinheiten für Prozessor und Graphikkarte fluidisch verbunden ist. Diese Ausführungsform des erfindungsgemäßen Kühlsystems ermöglicht erstmals eine völlig geräuschfreie Kühlung eines Personalcomputers für den Einsatz in Industrie, Büro oder als Heimcomputer.

Vorzugsweise werden die Kühleinheiten des Kühlsystems hintereinander angeordnet, so dass der Auslass der einen Kühleinheit mit dem Einlass einer folgenden Kühleinheit verbunden ist. Durch diese "In-Reihe-Schaltung" der einzelnen Kühleinheiten wird eine besonders wirksame Kühlung erzielt.

Das komplette Kühlsystem umfasst üblicherweise auch eine Flüssigkeitspumpe. Aus Sicherheitsgründen ist es ratsam, die Flüssigkeitspumpe mit der Stromversorgung des Prozessors zu verbinden, so dass diese immer in Betrieb ist, wenn der Rechner eingeschaltet wird. Eine Flüssigkeitspumpe mit mehrere Ausgängen für die Kühlflüssigkeit kann auch entsprechend mehrere Kühlsysteme mit Kühlflüssigkeit versorgen.

In einer bevorzugten Ausführungsform ist das erfindungsgemäße Kühlsystem so ausgelegt, dass ein gebläsefreier und somit vollkommen geräuschloser Rechner erhalten wird.

Es hat sich als günstig erwiesen, dass innerhalb des Rechners ein geschlossener Flüssigkeitsbehälter für die Kühlflüssigkeit angeordnet ist, mit dem die Kühleinheiten flüssigkeitsdicht verbunden sind. Die Kühlflüssigkeit wird im Kreislauf aus dem Flüssigkeitsbehälter in die einzelnen Kühleinheiten umgepumpt. Dadurch, dass der Flüssigkeitsbehälter geschlossen ausgebildet ist, wird der Austritt von Flüssigkeit in den Rechner verhindert und der Verdampfungsverlust der Kühlflüssigkeit verringert.

Durch diese etwas aufwendigere Maßnahme wird Feuchtigkeit im Rechner besonders effektiv vermieden, was insbesondere bei Rechnern für den industriellen Einsatz vorteilhaft sein kann.

Nachfolgend wird die Erfindung anhand von Ausführungsbeispielen und einer Zeichnung näher erläutert. In der Zeichnung zeigen in schematische Darstellung im einzelnen:
- **Figur 1**: eine Anordnung eines elektronischen Bauteil und einer befestigten Kühleinheit in einer ersten Ausführungsform in Seitenansicht,
- **Figur 2**: die in Figur 1 dargestellte Anordnung in einer Draufsicht,
- **Figur 3**: eine Anordnung eines elektronischen Bauteil und einer befestigten Kühleinheit in einer zweiten Ausführungsform in Seitenansicht,
- **Figur 4**: die in Figur 3 dargestellte Anordnung in einer Draufsicht,
- **Figur 5**: einen mit dem erfindungsgemäßen Kühlsystems ausgestatteten Rechner, mit Kühleinheiten für Prozessor, Graphikkarte und Festplatte.

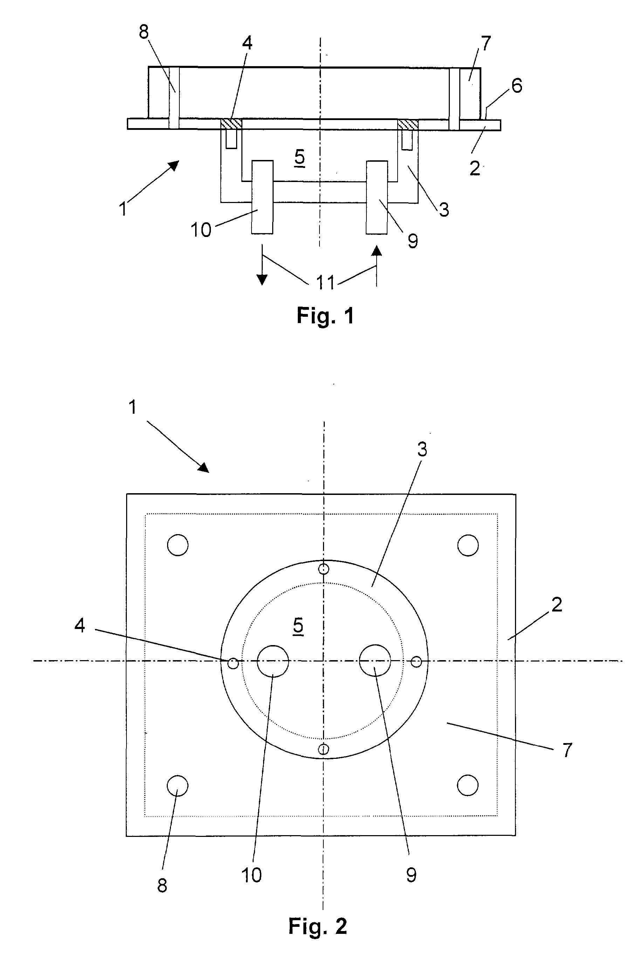

Bei der in **Figur 1** dargestellten Anordnung ist die Bezugsziffer 1 einer erfindungsgemäßen Kühleinheit insgesamt zugeordnet. Die Kühleinheit 1 umfasst eine Basisplatte 2 aus Aluminium und ein becherförmiges Hohlprofil 3 aus einem PE-Kunststoff mit rundem Querschnitt.

Die Basisplatte 2 ist quadratisch mit Seitenlängen von 50 x 50 mm ausgebildet und sie hat eine Dicke von 3 mm. Sie ist auf dem freien Rand des becherförmigen Hohlprofils 3 aufgeklebt und verschließt dessen Öffnung flüssigkeitsdicht. Die Basisplatte 2 ist auf dem Hohlprofil 3 zusätzlich durch Schrauben 4 fixiert. Die Basisplatte 2 umschließt mit dem Hohlprofil 3 einen Hohlraum 5. Mit ihrer dem Hohlraum 5 abgewandten flachen Oberseite 6 liegt die Basisplatte 2 an einem Mikroprozessor 7 an. Um einen guten Wärmeübergang zwischen Mikroprozessor 7 und der Kühleinheit 1 zu gewährleisten, ist eine Schraubverbindung 8 vorgesehen.

Das Hohlprofil 3 hat einen Außendurchmesser von ca. 50 mm, einen Innendurchmesser von ca. 40 mm und eine Höhe von ca. 18 mm. Der Hohlraum 5 wird durch Ausfräsen aus einem Vollzylinder mit dem Außendurchmesser des Hohlprofils 3 hergestellt. Am Bodenbereich des Hohlprofils 3 ist ein Einlass 9 und ein Auslass 10 für einen Kühlwasserstrom, der schematisch durch die Richtungspfeile 11 symbolisiert ist, vorgesehen. Einlass 9 und Auslass 10 sind als Verbindungselemente (Fittings) für eine Kühlwasserschlauch ausgebildet, die im Hohlprofil 3 flüssigkeitsdicht eingeklebt sind. Der Kühlwasserstrom 11 wird erzeugt, indem ein - in Figur 1 nicht dargestelltes - Kühlwasserreservoir von etwa 1 l destilliertem Wasser mittels einer Flüssigkeitspumpe kontinuierlich umgepumpt wird.

In der Draufsicht von **Figur 2** werden zur Bezeichnung der Bauteile und Bestandteile der Kühleinheit 1 die gleichen Bezugsziffern wie in Figur 1 verwendet. Auf die obigen Erläuterungen wird hingewiesen. Aus der Darstellung ist insbesondere der kreisförmige Querschnitt des Hohlprofils 3 und die Anordnung von Einlass 9 und Auslass 10 am Hohlprofil 3 ersichtlich.

Nachfolgend wird die Verwendung der in den Figuren 1 und 2 dargestellten Kühleinheit 1 zur Kühlung von übertakteten Mikroprozessoren in Personalcomputern anhand von Beispielen näher beschrieben.

### Beispiel 1:

Zur Übertaktung eines Rechners mit einem Sockel-7 Prozessor der Firma AMD (AMD K6-2 380 MHz) wird zunächst die Kühleinheit 1 am Prozessor befestigt, wie dies in Figur 1 dargestellt ist. Die Busgeschwindigkeit des Rechners wird auf 100 MHz und der Multiplikator auf 4,5 eingestellt, so dass eine Taktrate von 450 MHz erhalten wird. Mit dem Einschalten des Rechners wird automatisch die Flüssigkeitspumpe gestartet, so dass der Kühlwasserstrom 11 mit einem Volumenstrom von etwa 3 l/min die Kühleinheit durchströmt. Das Kühlwasser hat zunächst Raumtemperatur (ca. 24 °C) Die Temperatur des Mikroprozessors wird kontinuierlich überwacht. Nach einiger Zeit stellt sich eine konstante Temperatur von 29 °C ein.

### Beispiel 2:

Auf ähnliche Weise lässt sich auch ein Rechner mit einem Prozessor der Firma Intel (Celeron 300A) übertakten und mittels der erfindungsgemäßen Kühleinheit 1 ausreichend kühlen. Beim Celeron 300A ist die normale Busgeschwindigkeit mit 66 MHz und der Multiplikator mit 4,5 vorgegeben. Die Betriebsspannung liegt bei 2,0 V. Durch Erhöhen der Betriebsspannung auf 2,2 V kann die Busgeschwindigkeit auf 504 MHz erhöht werden. Um ein Überhitzen des so übertakteten Prozessors zu verhindern, wird die Kühleinheit 1 am Prozessor befestigt, wie dies in Figur 1 dargestellt ist und mit dem Einschalten des Rechners automatisch die Flüssigkeitspumpe gestartet, so dass der Kühlwasserstrom 11 (mit einer Anfangstemperatur von 24 °C) mit einem Volumenstrom von etwa 3 l/min die Kühleinheit durchströmt. Dabei wird die Temperatur des Mikroprozessors kontinuierlich überwacht. Nach einiger Zeit stellt sich eine konstante Temperatur von 31 °C ein.

### Beispiel 3:

Zur Übertaktung eines Rechner mit einem anderen Prozessor der Firma Intel (Pentium II 266; Serie: SL269) wird die normale Busgeschwindigkeit von 66 MHz (Multiplikator = 4) auf 112 MHz erhöht, und der Multiplikator auf 3 eingestellt, so dass eine Busgeschwindigkeit von 336 MHz erhalten wird. Um ein Überhitzen des so übertakteten Prozessors zu verhindern, wird die Kühleinheit 1 am Prozessor befestigt, wie dies in Figur 1 dargestellt ist und mit dem Einschalten des Rechners automatisch die Flüssigkeitspumpe gestartet, so dass der Kühlwasserstrom 11 (mit einer Anfangstemperatur von 24 °C) mit einem Volumenstrom von etwa 3 l/min die Kühleinheit durchströmt. Dabei wird die Temperatur des Mikroprozessors kontinuierlich überwacht. Nach einiger Zeit stellt sich eine konstante Temperatur von 38 °C ein.

### Beispiel 4:

Auch ein älteres Modell eines Prozessors der Firma Intel (Pentium 75) lässt sich unter Einsatz der erfindungsgemäßen Kühleinheit 1 problemlos übertakten. Bei einer Busgeschwindigkeit von 120 MHz wurde keine signifikante Temperaturerhöhung des Mikroprozessors festgestellt.

Die in den Beispielen 1 bis 4 erläuterten Verfahrensweisen zur Kühlung übertakteter Mikroprozessoren zeigen, dass die Prozessoren auf einer Temperatur gehalten werden können, die weit unterhalb der üblichen Betriebstemperaturen bei Luftkühlung liegen. Die erfindungsgemäße Kühleinheit verhindert somit nicht nur ein Erwärmen des Prozessors, sondern sie bewirkt im Vergleich zu der üblichen Luftkühlung darüberhinaus auch eine geringere Betriebstemperatur.

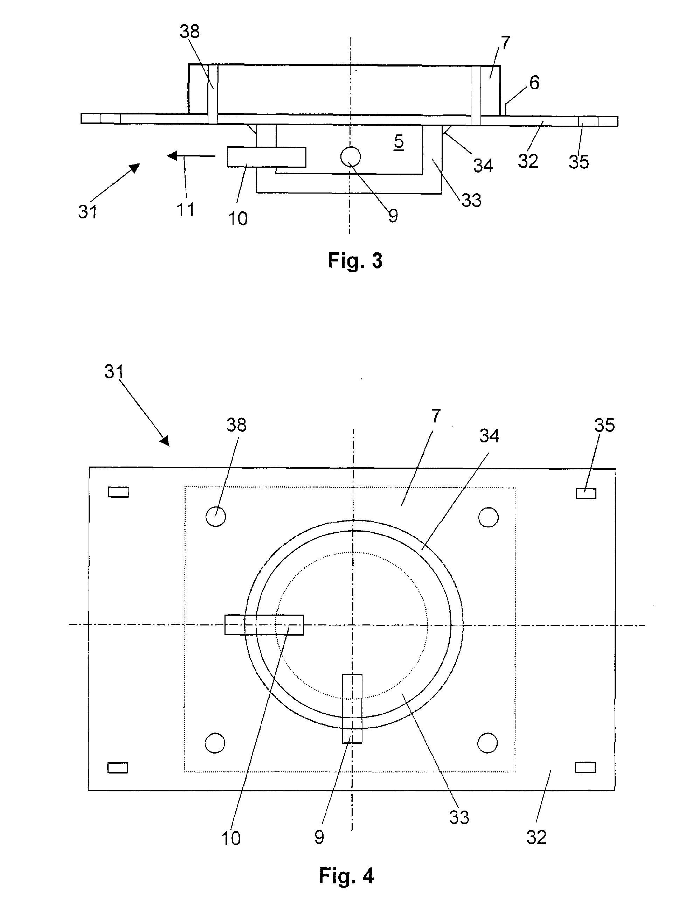

Sofern in den Figuren 3 und 4 die gleichen Bezugsziffern wie in den Figuren 1 und 2 verwendet werden, so sind damit identische oder äquivalente Bauteile und Bestandteile der Kühleinheit bezeichnet, wie sie oben anhand den Figuren 1 und 2 erläutert sind. Auf die entsprechenden Erläuterungen wird hingewiesen.

Bei der in **Figur 3** dargestellten Anordnung ist die Bezugsziffer 31 einer erfindungsgemäßen Kühleinheit insgesamt zugeordnet. Die Kühleinheit 31 umfasst eine rechteckige Basisplatte 32 aus Aluminium und ein becherförmiges Hohlprofil 33 aus Aluminium mit rundem Querschnitt.

Die Basisplatte 32 hat eine Dicke von 3 mm und seitliche Abmessungen von 50 x 120 mm. Die Basisplatte 32 ist auf dem freien Rand des becherförmigen Hohlprofils 33 angeschweißt. Die umlaufende Schweißnaht 34 gewährleistet eine flüssigkeitsdichte Verbindung zwischen Basisplatte 32 und Hohlprofil 33. Die Basisplatte 32 umschließt mit dem Hohlprofil 33 einen Hohlraum 5. Mit ihrer dem Hohlraum 5 abgewandten flachen Oberseite 6 (Kontaktfläche) liegt die Basisplatte 2 an einem Mikroprozessor 7 an. Die Basisplatte 32 ist am Mikroprozessor 7 mittels zweier Federbügel 38 festgeklemmt. Dadurch wird ein guter Wärmeübergang zwischen Mikroprozessor 7 und der Kühleinheit 31 gewährleistet. Die Kontaktfläche ist zusätzlich mit Wärmeleitpaste versehen. Die Federbügel 38 rasten in Ausnehmungen der Basisplatte 32 ein, die in einem ersten Rechteckraster angeordnet sind. Die Basisplatte 32 weist zusätzliche Ausnehmungen 35 auf, die in einem zweiten Rechteckraster angeordnet sind. Das im zweiten Rechteckraster angeordneten Ausnehmungen 35 sind im Hinblick auf die Befestigung der Kühleinheit 31 an einem anderen elektronischen Bauteil ausgelegt.

Das Hohlprofil 33 hat einen Außendurchmesser von ca. 50 mm, einen Innendurchmesser von ca. 40 mm und eine Höhe von ca. 18 mm. Der Hohlraum 5 wird durch Ausfräsen aus einem Vollzylinder mit dem Außendurchmesser des Hohlprofils 33 hergestellt. Im Bereich der Zylindermantelfläche des Hohlprofils 33 ist ein Einlass 9 und ein Auslass 10 für einen Kühlwasserstrom vorgesehen, der schematisch durch den Richtungspfeil 11 symbolisiert ist, vorgesehen. Der Kühlwasserstrom 11 wird erzeugt, indem ein - in Figur 1 nicht dargestelltes-Kühlwasserreservoir mittels einer Flüssigkeitspumpe kontinuierlich umgepumpt wird.

In der Draufsicht von **Figur 4** werden zur Bezeichnung der Bauteile und Bestandteile der Kühleinheit 31 die gleichen Bezugsziffern wie in Figur 3 verwendet. Auf die obigen Erläuterungen wird hingewiesen. Aus der Darstellung ist insbesondere der kreisförmige Querschnitt des Hohlprofils 33, die umlaufende Schweißnaht 34 und die Anordnung von Einlass 9 und Auslass 10 am Hohlprofil 3 ersichtlich.

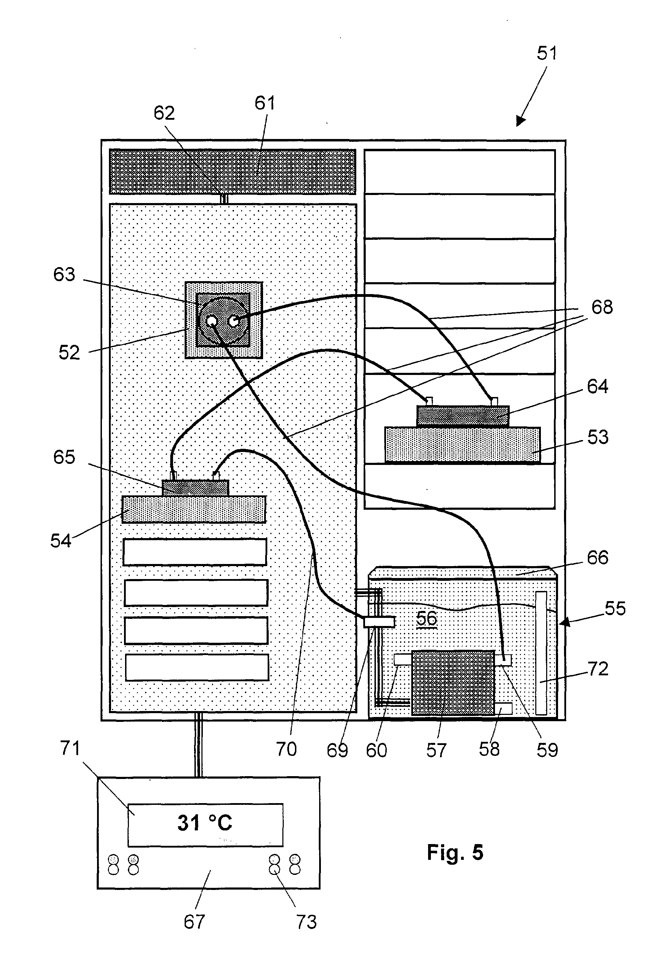

Der in **Figur 5** schematisch dargestellte Rechner umfasst einen Mikroprozessor 52, eine Festplatte 53 und eine Graphikkarte 54. Im unteren Bereich des Rechners 51 ist ein Behälter 55 angeordnet, der mit 1 Liter destilliertem Wasser 56 gefüllt ist. Innerhalb des Behälters 55 ist eine Flüssigkeitspumpe 57 fixiert, die zwei Auslässe 58, 59 und einen Einlass 60 die Kühlflüssigkeit (destilliertes Wasser 56) aufweist. Der Behälter 55 ist mit einem Deckel 66 flüssigkeitsdicht verschlossen. Mikroprozessor 52, Festplatte 53, Graphikkarte 54 und Flüssigkeitspumpe 57 sind mit einem Netzteil 61 elektrisch verbunden, wobei die Verbindungen durch Leitungen 62 angedeutet sind.

Der Rechner 51 ist mit einem Kühlsystem gemäß dieser Erfindung ausgestattet. Zu dem Kühlsystem gehören drei erfindungsgemäße Kühleinheiten 63, 64, 65 für den Mikroprozessor 52, die Festplatte 53 und die Graphikkarte 54 und die dafür benötigten Verbindungsschläuche 68, der Behälter 55 inklusive der Flüssigkeitspumpe 57 sowie eine Anzeige- und Auswerteeinheit 67, sowie die erforderlichen elektrischen Bauteile.

Die Kühleinheiten 63, 64 und 65 sind über die Verbindungsschläuche 68 mit der Flüssigkeitspumpe 57 und miteinander derart in Reihe verbunden, dass der Auslass der einen Kühleinheit 63, 64 jeweils mit dem Einlass der nächsten Kühleinheit 64, 65 verbunden ist, wobei der Einlass der Kühleinheit 63 für den Mikroprozessor 52 mit dem Auslass 59 der Flüssigkeitspumpe 57 verbunden ist und der Kunststoffschlauch 70 vom Auslass der Kühleinheit 65 für die Graphikkarte 54 über eine flüssigkeitsdichte Durchführung 69 in den Behälter 55 geführt ist.

Die Oberflächentemperatur des Mikroprozessors 52 wird kontinuierlich gemessen. Der Messwert wird der Anzeige- und Auswerteeinheit 67 zugeführt und auf einem Display 71 angezeigt. Außerdem wird die Feuchtigkeit innerhalb des Rechners 51 mittels eines Feuchtigkeitssensors, der Durchfluss des Kühlwassers mittels eines Durchfluss-Sensors und der Füllstand im Behälter 55 mittels eines Füllstandsmessers 72 erfasst. Bei Über- bzw. bei Unterschreiten eines vorgegebenen Sollwerts leuchtet bei der Anzeige- und Auswerteeinheit 67 ein entsprechendes LED 73 auf und es ertönt ein Warnsignal.

Beim Einschalten des Netzteils 61 wird die Flüssigkeitspumpe 57 automatisch gestartet. Die Pumpleistung beträgt 3 l/min. Durch den Kühlwasserstrom werden der Mikroprozessor 52, die Festplatte 53 und die Graphikkarte 54 lautlos gekühlt; der Rechner 51 arbeitet geräuschlos.

## Patentansprüche

1. Kühleinheit für ein elektronisches Bauteil, umfassend ein Gehäuse, das einen Einlass und einen Auslass für eine Kühlflüssigkeit aufweist, und das mit einer metallischen Kühlfläche versehen ist, die mit dem elektronischen Bauteil in flächigem, thermischen Kontakt steht, **dadurch gekennzeichnet, dass** das Gehäuse ein einseitig offenes Hohlprofil (3, 31) umfasst, das mit einer Kühlplatte (2, 32), die mit dem elektronischen Bauteil (7) in flächigem, thermischen Kontakt steht, flüssigkeitsdicht verschlossen ist.

2. Kühleinheit nach Anspruch 1, **dadurch gekennzeichnet, dass** das Hohlprofil (3, 31) einstückig aus einem Metall- oder Kunststoffteil gefertigt ist.

3. Kühleinheit nach Anspruch 1 oder 2, **dadurch gekennzeichnet, dass** das Hohlprofil (3, 31) in einer Ebene parallel zur Flachseite (6) der Kühlplatte (2, 32) einen runden Innenquerschnitt aufweist.

4. Kühleinheit nach einem der vorhergehenden Ansprüche, **dadurch gekennzeichnet, dass** die Kühleinheit (1, 31) mit dem elektronischen Bauteil (7) lösbar verbunden ist.

5. Kühleinheit nach einem der vorhergehenden Ansprüche, **dadurch gekennzeichnet, dass** die Kühlplatte (31) mit Öffnungen (32, 38) versehen ist, die in einem Raster oder in mehreren vorgegebenen Rastern angeordnet sind.

6. Kühleinheit nach einem der vorhergehenden Ansprüche, **dadurch gekennzeichnet, dass** sie einen mit einer Warnvorrichtung versehenen Temperatursensor umfasst.

7. Kühleinheit nach einem der vorhergehenden Ansprüche, **dadurch gekennzeichnet, dass** sie einen mit einer Warnvorrichtung versehenen Feuchtigkeitssensor umfasst.

8. Kühleinheit nach einem der vorhergehenden Ansprüche, **dadurch gekennzeichnet, dass** sie eine mit einer Warnvorrichtung versehene Durchfluss-Sensor umfasst.

9. Kühleinheit nach einem der vorhergehenden Ansprüche, **dadurch gekennzeichnet, dass** sie einen mit einer Anzeigevorrichtung (67, 73) versehenen Füllstandssensor (72) umfasst.

10. Kühleinheit nach einem der vorhergehenden Ansprüche, **dadurch gekennzeichnet, dass** das elektronische Bauteil ein Graphikkarte (54) ist.

11. Kühleinheit nach einem der vorhergehenden Ansprüche, **dadurch gekennzeichnet, dass** das elektronische Bauteil eine Festplatte (53) ist.

12. Kühlsystem für einen elektronischen Rechner, der einen Prozessor, eine Graphikkarte und eine Festplatte aufweist, **dadurch gekennzeichnet, dass** der Prozessor (52) und die Graphikkarte (54) jeweils mit mindestens einer Kühleinheit (63, 65) nach einem der vorhergehenden Ansprüche in thermischem Kontakt sind, wobei die Kühleinheiten (63, 65) fluidisch miteinander verbunden sind.

13. Kühlsystem nach Anspruch 12, **dadurch gekennzeichnet, dass** es eine weitere, mit der Festplatte (53) in thermischem Kontakt stehende Kühleinheit (64) umfasst, die mit den Kühleinheiten (63, 65) für Prozessor (52) und Graphikkarte (54) fluidisch verbunden ist.

14. Kühlsystem nach Anspruch 12 oder 13, **dadurch gekennzeichnet, dass** die Kühleinheiten (63, 64, 65) hintereinander angeordnet sind, indem der Auslass der einen Kühleinheit (63, 64) mit dem Einlass einer folgenden Kühleinheit (64, 65) verbunden ist.

15. Kühlsystem nach Anspruch 12 oder 13, **dadurch gekennzeichnet, dass** es eine Flüssigkeitspumpe (57) umfasst, die mit der Stromversorgung (61) des Prozessors (52) verbunden ist.

16. Kühlsystem nach einem der Ansprüche 12 bis 15, **dadurch gekennzeichnet, dass** der Rechner (51) gebläsefrei ist.

17. Kühlsystem nach einem der Ansprüche 12 bis 16, **dadurch gekennzeichnet, dass** innerhalb des Rechners (51) ein geschlossener Flüssigkeitsbehälter (55) für die Kühlflüssigkeit (56) angeordnet ist, mit dem die Kühleinheiten (63, 64, 65) flüssigkeitsdicht verbunden sind.
